# DEMANDE DE BREVET EUROPEEN

(11) **EP 1 079 234 A1**
(43) Date de publication de la demande: **28.02.2001**
(21) Numéro de dépôt: 00420178.6
(22) Date de dépôt: 17.08.2000
(51) Int. Cl.: G01R 31/00

(54) **Système et procédé de diagnostic de panne affectant un appareil électrique ou électronique d'un véhicule automobile**

(30) Priorité: 20.08.1999 FR 9910757
(71) Demandeur: Cora Gaz, 69970 Chaponnay (FR)
(72) Inventeur: Perez, Georges, 69720 Saint Bonnet de Mure (FR)
(74) Mandataire: Myon, Gérard Jean-Pierre

(57) **Abrégé**

Ce système comprend :
- un boîtier (1) comprenant plusieurs bornes de contrôle (104),
- un jeu de cordons (3, 20) permettant de relier sélectivement les bornes de contrôle (104) à différents appareils électriques ou électroniques (30), et
- des outils (40, 50) de guidage d'un utilisateur pour le raccordement des bornes de contrôle (104), en fonction du ou des cordons utilisés (3, 20) et de l'appareil (30) sur un connecteur (31) duquel est raccordé le boîtier (1) par le ou les cordons.
Le boîtier (1) est équipé de bornes (111, 112) d'alimentation/simulation qui peuvent être raccordées aux bornes de contrôle (104) et sont situées dans une partie (103) du boîtier (1) voisine de celle (102) dans laquelle sont disposées les bornes de contrôle (104).

## Description

L'invention concerne un système et un procédé de diagnostic de panne affectant un appareil électrique ou électronique d'un véhicule automobile.

Les véhicules automobiles comprennent de nombreux dispositifs électriques ou électroniques de commande ou de contrôle du moteur et d'équipements périphériques de confort ou de sécurité. Comme tous les équipements d'un véhicule, ces appareils sont susceptibles de panne, notamment pour cause d'usure normale ou anormale ou en cas d'accident du véhicule. Compte tenu du grand nombre de ces dispositifs et de leur relative complexité, tant en ce qui concerne leur structure qu'en ce qui concerne leur agencement à l'intérieur du véhicule, il est connu, par exemple de FR-A-2 674 023, d'utiliser un système électronique branché sur un module d'interface central du véhicule comprenant un calculateur de gestion des appareillages électriques.

Un tel système doit être informatiquement compatible avec le calculateur, c'est-à-dire, en pratique, être dédié à une marque de véhicules, voire à certains modèles de cette marque. Certains équipementiers automobiles proposent des systèmes de diagnostic pour leurs produits montés sur des véhicules. Dans ce cas, le système connu est compatible avec les produits d'un seul équipementier. Ceci impose à un garagiste de disposer de plusieurs systèmes de diagnostic adaptés aux véhicules de sa clientèle, de tels systèmes constituant des matériels onéreux, car ils incorporent des développements logiciels élaborés. En pratique, un garagiste représentant une marque doit intervenir pour la maintenance de véhicules de marques diverses et il n'est pas rare que plus de la moitié des interventions de maintenance soient effectuées sur des véhicules de marques autres que la marque dont le garage est l'agent. Pour cette majorité des véhicules, les professionnels ne disposent généralement pas de tels matériels de coûts élevés. En outre, les évolutions des véhicules ne sont pas facilement prises en compte par ce genre de systèmes, sauf à prévoir une procédure complexe de chargement et de mise à jour des fichiers informatiques des boîtiers.

Par ailleurs, ces boîtiers sont essentiellement dépendants de la qualité des informations fournies par le module central d'interface du véhicule et ne sont pas efficaces dès lors que ce module est en panne et/ou qu'il est incorrectement raccordé à son environnement.

US-A-4,567,756 divulgue un appareil de contrôle d'un système d'injection de carburant dans un moteur qui doit être associé à un appareil de mesure externe, par exemple un oscilloscope. Cet appareil n'est donc pas autonome et sa manipulation est relativement complexe. En outre, cet appareil doit être connecté au système électronique spécifique de gestion du véhicule et ne permet pas d'accéder à des composants indépendamment de ce système. Le contacteur rotatif qu'il comprend impose le type de raccordement entre l'appareil de mesure externe et le cordon relié au véhicule.

Les systèmes connus sont capables de détecter un environnement de panne, c'est-à-dire une zone physique ou une fonction du véhicule qui est en défaut, mais ne permettent généralement pas de détecter la nature de la panne ni l'appareil ou le composant affecté. En effet, les techniciens sont uniquement censés recueillir des informations relatives aux dysfonctionnements sans réelle précision sur leur origine et sans garantie quant à leur véracité. Il en résulte une surconsommation de pièces de rechange que doit généralement supporter financièrement le propriétaire du véhicule, sans que la panne soit nécessairement résolue.

C'est à ces inconvénients qu'entend plus particulièrement remédier l'invention en proposant un système de diagnostic qui n'est pas tributaire du calculateur central d'un véhicule et qui peut être mis en oeuvre sur des véhicules de marques différentes, alors que son prix de revient est sensiblement inférieur à celui des matériels connus et qu'il peut être aisément adapté aux évolutions des véhicules automobiles.

Dans cet esprit, l'invention concerne un système de diagnostic de panne affectant un appareil électrique ou électronique d'un véhicule automobile, ledit système comprenant :
- un boîtier comprenant plusieurs bornes de contrôle,
- un jeu de cordons permettant de relier sélectivement les bornes de contrôle à différents appareils électriques ou électroniques du véhicule, ces cordons étant aptes à être branchés sur au moins un connecteur prévu sur l'appareil et
- des outils de guidage d'un utilisateur pour le raccordement des bornes de contrôle, en fonction du ou des cordons utilisés et de l'appareil sur un connecteur duquel est raccordé le boîtier par le ou les cordons,
caractérisé en ce que le boîtier est équipé de bornes d'alimentation/simulation aptes à être reliées électriquement aux bornes de contrôle.

Grâce à l'invention, la détection des éventuels défauts de chaque appareil peut être effectuée en branchant un cordon adapté au connecteur d'alimentation et de contrôle de cet appareil et en utilisant le boîtier pour simuler l'environnement de cet appareil en fonction de ses conditions normales de fonctionnement. En d'autres termes, le système de l'invention permet de contrôler individuellement chaque appareil sans passage obligé par le calculateur d'un module d'interface central. L'invention prend donc le contre-pied de la tendance dominante dans le domaine considéré qui tend à une automatisation des fonctions de contrôle, les techniciens automobiles étant uniquement censés brancher un dispositif complexe sur un calculateur d'interface. L'invention requiert du technicien une approche logique pour se connecter aux différents appareils en fonction de la nature des pannes ou anomalies constatées, le système de l'invention étant avant tout une aide, la logique et l'interprétation restant, pour partie, à l'initiative du technicien. L'invention ne nécessite pas d'utiliser un oscilloscope ou un autre appareil de mesure car le boîtier incorpore les bornes d'alimentation/simulation qui permettent de simuler, à travers les bornes de contrôle auxquelles elles sont reliées, des conditions de fonctionnement de l'appareil à contrôler.

Selon des aspects avantageux mais non obligatoires de l'invention, le système intègre une ou plusieurs des caractéristiques suivantes :
- Le boîtier est équipé d'un connecteur dont le nombre de voies est au moins égal au nombre de bornes de contrôle. Ce connecteur permet l'utilisation d'un cordon unique pour le branchement des bornes de contrôle à l'appareil à vérifier.
- Le jeu de cordons inclut une rallonge comprenant un cordon primaire, équipé de conducteurs en nombre au moins égal au nombre de bornes de contrôle, et un cordon d'alimentation du boîtier, apte à être relié aux bornes d'une batterie d'accumulateurs du véhicule. Cette rallonge permet, d'une part, d'alimenter le boîtier avec la tension de référence du véhicule et, d'autre part, de déporter un connecteur à proximité de l'appareil à vérifier.
- Le jeu de cordons comprend plusieurs cordons équipés d'un connecteur primaire de nombre de voies supérieur ou égal au nombre de bornes de contrôle et de plusieurs connecteurs secondaires de nombre de voies et de géométrie variables. Chacun de ces cordons peut être branché à l'extrémité de la rallonge par son connecteur primaire et, en fonction du type et de la géométrie du connecteur de l'appareil à vérifier, branché sur cet appareil par l'un de ses connecteurs secondaires. Dans ce cas, les connecteurs secondaires peuvent comprendre plusieurs connecteurs mâles et/ou femelles reliés en parallèle au connecteur primaire, le connecteur secondaire adapté au connecteur de l'appareil à vérifier étant utilisé. On peut en outre prévoir que les connecteurs secondaires sont compatibles avec des connecteurs de même nombre de voies prévus sur les appareils, indépendamment d'un éventuel système de détrompage, par suppression d'une partie de ces connecteurs secondaires intégrant habituellement un système de détrompage, notamment par enlèvement de matière.
- Les bornes d'alimentation/simulation comprennent :
   - les bornes de sortie d'une alimentation en tension continue variable ;
   - les bornes d'une résistance variable ;
   - une borne d'un testeur de polarité ;
   - les bornes d'un générateur d'impulsion et/ou
   - des bornes reliées aux bornes de la batterie d'accumulateurs du véhicule. Ces différentes bornes d'alimentation/simulation permettent d'appliquer, à une ou plusieurs des bornes de contrôle, des signaux ou de prélever sur celles-ci des signaux permettant de simuler l'environnement de l'appareil afin de vérifier et de contrôler son fonctionnement.
- Il est prévu un jeu de plaquettes aptes à être sélectivement disposées sur une façade sur laquelle sont prévues les bornes de contrôle, en fonction du ou des cordons utilisés et de l'appareil à vérifier. Chaque plaquette porte des moyens d'identification des bornes de contrôle permetant d'identifier l'affectation des voies du connecteur utilisé. Les plaquettes constituent donc un outil efficace de guidage de l'utilisateur, éventuellement en conjonction avec une documentation associée.
- Une documentation est prévue qui permet de sélectionner, en fonction du véhicule et de l'appareil à vérifier, le cordon à utiliser, de connaître les branchements à effectuer entre les bornes du boîtier et de spécifier les résultats à obtenir. Cette documentation peut concerner les véhicules de l'ensemble du marché et n'est donc pas limitée à une marque, à un type de véhicules ou à une marque d'équipements, ce qui confère une certaine universalité au système de l'invention. Une telle documentation peut être facilement mise à jour, notamment dans le cas d'une documentation sous forme de fiches, intégrées dans un classeur, ou sous forme de fichiers informatiques, qui peut être aisément transmise à un réseau de garagistes. Toute autre forme de documentation, notamment par cassette vidéo, peut être envisagée.

L'invention concerne également un procédé de diagnostic de panne qui peut être mis en oeuvre avec le système tel que précédemment et, plus spécifiquement, un procédé qui comprend une étape consistant à :
- relier les bornes de contrôle avec certaines bornes d'alimentation/simulation prévues sur ledit boîtier, selon des indications fournies par des outils de guidage en fonction du type de l'appareil et du ou des cordons utilisés pour brancher le boîtier sur le connecteur.

Le raccordement des bornes et la vérification du fonctionnement, conforme ou non, sont effectués au moyen de la documentation, ceci pouvant concerner un ou plusieurs appareils qu'on active et dont on mesure la réaction, au niveau d'une, de plusieurs ou de toutes leurs fonctions. La documentation permet au technicien automobile d'acquérir un complément de connaissance des appareils en définissant un mode d'utilisation du système de l'invention, y compris ses accessoires. Ainsi, le rôle du technicien ne se limite plus au branchement d'une prise sur un module d'interface. En revanche, le procédé de l'invention permet de connaître précisément quel est l'appareil en panne et, dans la plupart des cas, la nature de la panne, une action correctrice appropriée pouvant être envisagée par le technicien, en fonction de sa connaissance du véhicule.

L'invention sera mieux comprise et d'autres avantages de celle-ci apparaîtront plus clairement à la lumière de la description qui va suivre d'un système de diagnostic de panne et de son procédé de mise en oeuvre conformes à son principe, donnée uniquement à titre d'exemple et faite en référence aux dessins annexés dans lesquels :
- la figure 1 est une représentation schématique de principe, en perspective éclatée, d'un système conforme à l'invention en cours d'utilisation ;
- la figure 2 est une vue de la façade du boîtier du système de la figure 1 ;

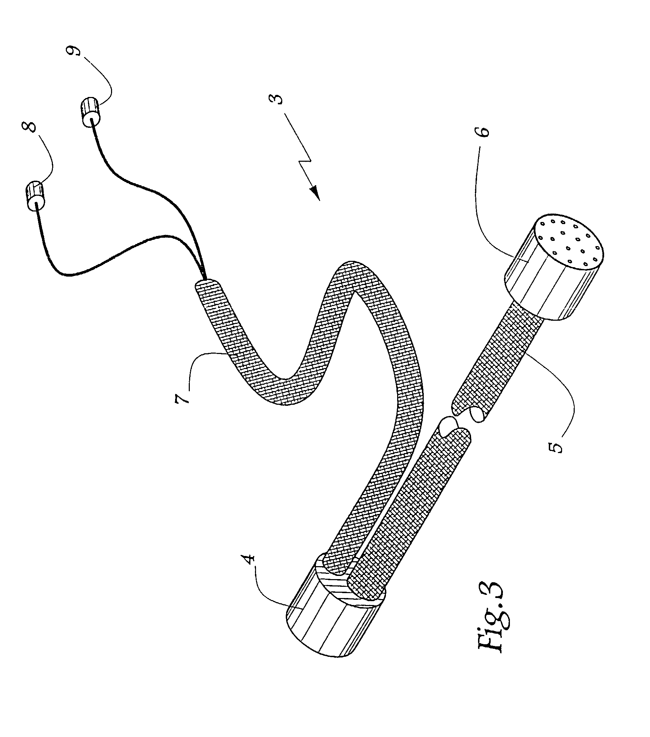

- la figure 3 est une représentation schématique de principe d'une rallonge du système de la figure 1 ;
- la figure 4 est une représentation schématique analogue à la figure 3 d'un premier cordon du système de la figure 1 ;
- la figure 5 est une vue analogue à la figure 4 pour un second cordon ;
- la figure 6 est une vue analogue à la figure 4 pour un troisième cordon ;
- la figure 7 est une représentation schématique partielle en perspective d'un connecteur d'extrémité d'un cordon du système de l'invention en cours de raccordement sur un connecteur d'un appareil électrique ;
- la figure 8 est un schéma de principe d'une première configuration d'utilisation du système de la figure 1 ;
- la figure 9 est un schéma de principe analogue à la figure 8 pour une seconde configuration d'utilisation et
- la figure 10 est un schéma de principe analogue à la figure 8 pour une troisième configuration d'utilisation.

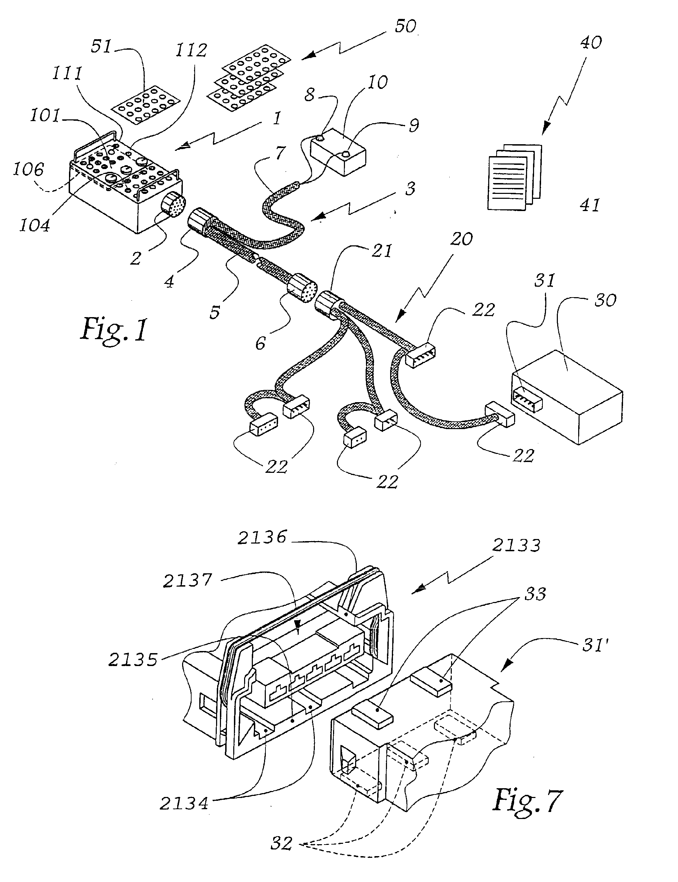

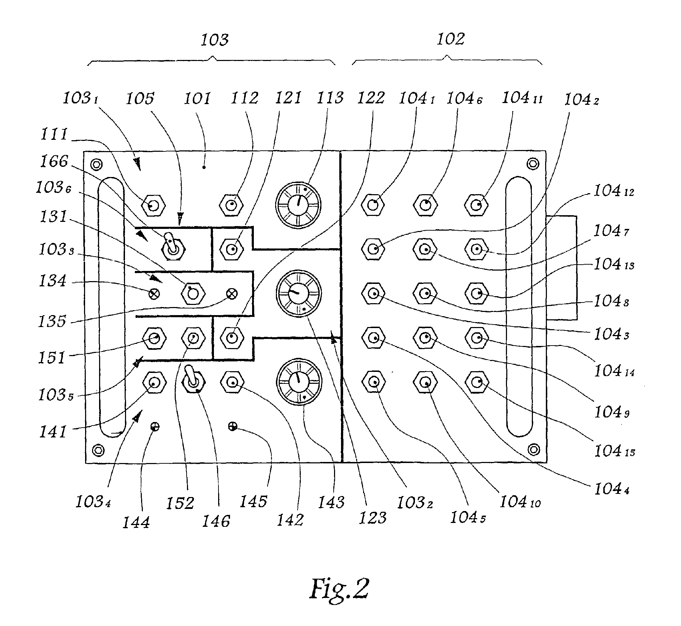

Le système représenté à la figure 1 comprend un boîtier 1, équipé d'un connecteur cylindrique 2 à vingt-quatre voies et dont la façade 101 apparaît plus clairement à la figure 2. Le système comprend également une rallonge 3 dont une extrémité est formée par un connecteur 4 à vingt quatre voies adapté pour être branché sur le connecteur 2. La rallonge 3 se divise en un cordon primaire 5, équipé d'un connecteur d'extrémité 6, et en un cordon d'alimentation 7 pourvu de deux fiches 8 et 9 de raccordement sur la batterie d'accumulateurs 10 du véhicule dont on doit vérifier le fonctionnement. Ainsi, le branchement du connecteur 4 sur le connecteur 2 et des fiches 8 et 9 permettent d'alimenter, avec une tension généralement de l'ordre de 12 volts, le boîtier 1.

Un cordon secondaire 20 est prévu pour être branché sur le connecteur 6 grâce à un connecteur primaire 21 de forme adaptée. Le cordon 20 comprend plusieurs connecteurs secondaires 22 reliés au connecteur 21 d'une façon expliquée dans ce qui suit. L'un des connecteurs 22 peut être relié à un connecteur 31 servant habituellement à l'alimentation et au contrôle d'un appareil électrique ou électronique 30.

Une documentation 40 est prévue sous forme de fiches 41, chaque fiche correspondant à un type de véhicule et à un ou plusieurs appareils 30 dont le fonctionnement doit être vérifié. Un jeu de plaquettes 50 est associé à la documentation 40, une plaquette 51 étant sélectionnée en fonction de la fiche 41 à utiliser et prévue pour être disposée sur une partie de la façade 101 du boîtier 1 qui apparaît plus clairement à la figure 2. Cette façade 101 est divisée en une partie formant bornier 102, prévue pour recevoir la plaquette 51, et en une partie 103 formant unité d'alimentation et de contrôle.

La partie 102 comprend quinze bornes 104₁ à 104₁₅ reliées chacune à une voie du connecteur 2. Ces bornes sont constituées de fiches femelles pouvant recevoir des fiches mâles de type Jack ou équivalent. Le cordon 5 comprend au moins quinze conducteurs correspondant respectivement à chacune des quinze bornes 104.

La partie 103 peut être divisée en six zones 103₁ à 103₆ séparées par des lignes sérigraphiées 105, une telle ligne 105 permettant également de séparer les zones 102 et 103 pour la clarté des manipulations du boîtier 1. Des bornes, des interrupteurs et des boutons de commande sont prévus dans la partie 103 et sont respectivement raccordés à un circuit électronique 106 intégré dans le boîtier 1.

La zone 103₁ est celle d'une alimentation en courant continu générée à partir de la tension obtenue grâce au cordon 7. Il est prévu dans la zone 103₁ deux bornes 111 et 112 pouvant respectivement être alimentées entre 0 et 1 volt et entre 0 et 5 volts et dont la tension d'alimentation est contrôlée grâce à un potentiomètre 113. Chacune des bornes 111 et 112 est formée par une fiche femelle de type Jack. Les bornes 111 et 112 sont prévues pour alimenter certaines bornes 104 et permettent d'alimenter et de simuler des appareils, tels que des capteurs, dont le signal de sortie varie respectivement entre 0 et 1 volt ou entre 0 et 5 volts, tels que par exemple une sonde à oxygène ou un capteur de pression.

La zone 103₂ comprend deux bornes 121 et 122 entre lesquelles est disposée une résistance variable dont la valeur est commandée grâce à un potentiomètre 123. La valeur de la résistance variable peut être fixée entre 0 et 10 kΩ et un branchement entre les deux bornes 121 et 122 permet de simuler un appareillage électrique, tel qu'un capteur d'une grandeur physique variable comme une température ou une position.

La zone 103₃ constitue un testeur de polarité et comprend une borne 131 associée à deux diodes électroluminescentes 134 et 135. Lorsqu'une tension est appliquée à la borne 131, la diode 134 est éclairée lorsque le potentiel de la borne 131 est décalé, jusqu'à une valeur de seuil prédéterminée, par rapport à une tension de référence qui peut être la masse de l'alimentation du boîtier, c'est-à-dire de la batterie 10. Au contraire, la diode 135 est éclairée lorsque la tension appliquée à la borne 131 est décalée d'une valeur minimum par rapport à la tension positive d'alimentation du simulateur, c'est-à-dire à la tension de sortie de la batterie 10. Le circuit 106 comprend une partie électronique adaptée à cette fonction et connecté sur deux liaisons électriques incorporant respectivement l'une des diodes 134 ou 135 et reliant la borne 131 à des pièces aux potentiels de référence, telles que des pistes du circuit 106 alimentées par le cordon 7.

La zone 103₄ constitue un moyen de génération d'impulsions, positives ou négatives, entre deux bornes 141 et 142, la fréquence de ces impulsions étant commandée grâce à un bouton 143. Un interrupteur à trois positions 146 permet de sélectionner une valeur de tension positive ou négative entre les bornes 141 et 142, le caractère positif ou négatif des impulsions générées entre les bornes 141 et 142 étant détecté par le clignotement de deux diodes 144 et 145 respectivement placées au voisinage des bornes 141 et 142.

La zone 103₅ comprend deux bornes 151 et 152 respectivement reliées aux bornes positive et négative de la batterie 10 par le cordon 7 et constituant des bornes de tension de référence.

La zone 103₆ comprend un interrupteur 166 de mise en marche du boîtier 1.

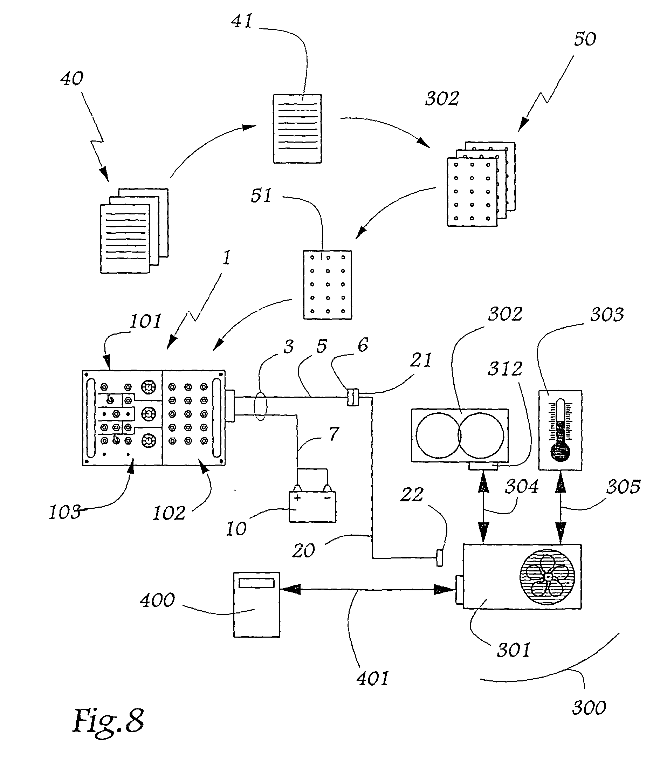

Le fonctionnement du système de l'invention est maintenant décrit en référence aux figures 8 à 10. On suppose que le système de climatisation 300 d'un véhicule automobile ne fonctionne pas correctement. Ce système comprend une unité centrale 301, un compresseur 302 et un capteur de température 303. Une liaison électrique 304 permet de commander le compresseur 302 à partir de l'unité 301 alors qu'une liaison du même type 305 permet de raccorder le capteur 303 à l'unité 301. L'unité 301 est, par ailleurs, reliée à un module formant calculateur central 400 du véhicule grâce à une liaison électrique 401.

Lorsque le type du véhicule et le type du système 300 ont été identifiés, la fiche correspondante 41 de la documentation 40 est identifiée et une plaquette 51 est sélectionnée et apposée sur la partie 102 de la façade 101. Cette plaquette 51 identifie chaque borne 104₁ à 104₁₅ de façon univoque alors que la fiche 41 indique à l'utilisateur quelles bornes doivent être reliées entre elles sur la façade 101. L'identification des bornes 104 permet de savoir à quoi sont reliées les voies du connecteur 31.

En fonction du type du connecteur 311 utilisé pour le raccordement de l'unité 301 à la ligne 401, il est possible de sélectionner un cordon secondaire 20 dont l'un des connecteurs secondaires 22 est adapté à la géométrie et au nombre de voies du connecteur 311. Ce choix est effectué grâce à la fiche 41 sur laquelle est portée l'information correspondante, à savoir la référence du cordon 20 à utiliser et celle du connecteur 22 adapté. Il est alors possible de connecter le boîtier 1 à l'unité 301 et, en suivant les indications de la fiche 41, de relier certaines des bornes 104 entre elles où à certaines des bornes de la partie 103 de façon à simuler des conditions de fonctionnement normal du système 300.

En pratique, on relie une ou plusieurs bornes de la partie 103 à une ou plusieurs bornes de contrôle 104, certaines bornes de la partie 103 ou certaines bornes de contrôle 104 pouvant être reliées entre elles. Ceci permet le contrôle d'un ou plusieurs appareils 30, éventuellement de façon simultanée. Une grande souplesse d'utilisation est ainsi obtenue.

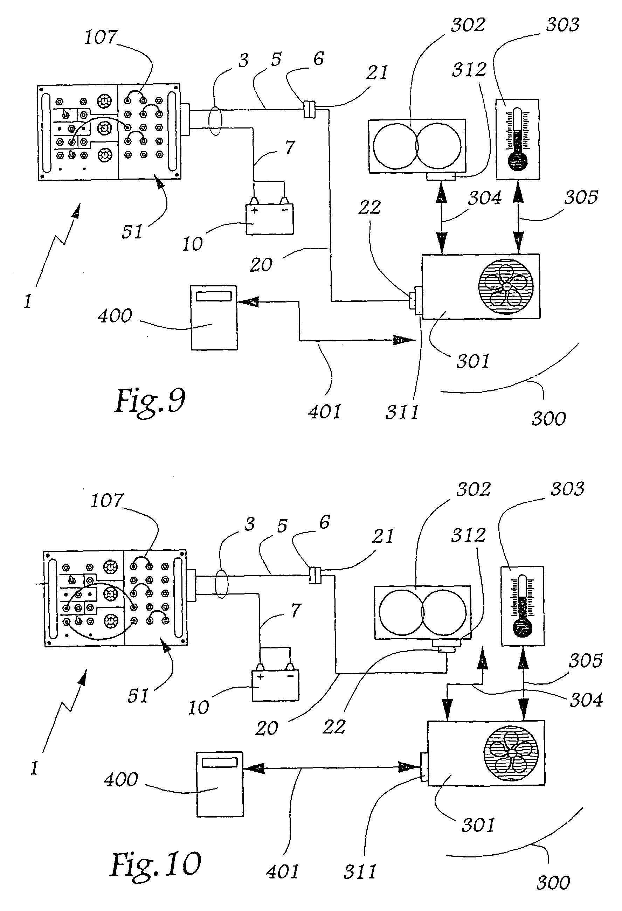

Comme représenté à la figure 9, l'utilisateur emploie pour ce faire des conducteurs souples 107 équipés de deux fiches Jack mâles qu'il insère dans l'une des bornes 104 et dans l'une des bornes de la partie 103 ou dans deux des bornes 104 selon les indications de la fiche 41 et/ou de la plaquette 51. Chaque borne de contrôle 104 peut ainsi être sélectivement reliée à une autre borne ou à l'une des bornes de la partie 103.

L'utilisateur branche alors directement un connecteur secondaire 22 du cordon 20 sur le connecteur d'entrée 311 de l'unité 301, à la place de la liaison 401, de sorte que le boîtier 1 peut simuler l'environnement du système 300 en adressant des signaux de commande appropriés à l'unité 301.

Si le système 300 fonctionne alors correctement et selon les indications portées sur la fiche 41, il est possible d'en conclure que le système de commande 400 ou équivalent est défectueux ou que la liaison 401 est défectueuse, les investigations pouvant être concentrées à ce niveau. Dans ce cas, le système permet une amélioration sensible par rapport aux dispositifs de l'art antérieur, car de tels dispositifs n'auraient pas permis d'identifier ce genre de panne puisque le calculateur 400 n'aurait pas fourni les informations correspondantes.

Si le système 300 ne fonctionne pas correctement, les éléments 302 et 303 peuvent alors être vérifiés individuellement, après que la liaison 401 ait été éventuellement rebranchée, selon une séquence précisée sur la fiche 41. Plus particulièrement, la liaison 304 est débranchée du côté du compresseur 302 et un nouveau cordon 20', choisi en fonction du type du connecteur 312 du compresseur 302, est utilisé pour relier le boîtier 1 au compresseur et, là encore, en fonction des indications de la fiche 41, on simule un ordre de fonctionnement du compresseur 302 tel qu'il devrait être transmis par l'unité 301. Si le compresseur fonctionne normalement, il est probable que l'unité 301, la liaison 304 ou un autre élément périphérique tel que le capteur 303 ou sa liaison 305 sont défectueux. Si le compresseur ne fonctionne pas, il est probable qu'il est défectueux.

En fonction des constatations effectuées sur le compresseur 302, une étape de contrôle ultérieure peut être effectuée sur le capteur 303 et, de façon générale, sur chacun des éléments constitutifs du système 300.

Au vu de ce qui précède, le système et le procédé de l'invention permettent de contrôler individuellement chaque appareil électrique ou électronique du véhicule en simulant, au niveau de son connecteur d'alimentation, des conditions normales de fonctionnement et en s'affranchissant d'une liaison informatique complexe avec le calculateur 400 ou un module d'interface analogue.

Comme la rallonge 3 est raccordée au boîtier 1, le cordon 5 doit avoir un nombre de conducteurs supérieur ou égal au nombre de bornes 104, c'est-à-dire supérieur ou égal à 15, dans l'exemple alors que deux conducteurs sont utilisés dans le cordon 7. Pour ce faire, le connecteur 4 doit avoir au moins 17 voies. En pratique on utilise un connecteur 24 voies, sept voies demeurant libres.

Le connecteur 6 est, quant à lui un connecteur femelle à seize voies dont quinze voies sont utilisées, la seizième voie étant libre.

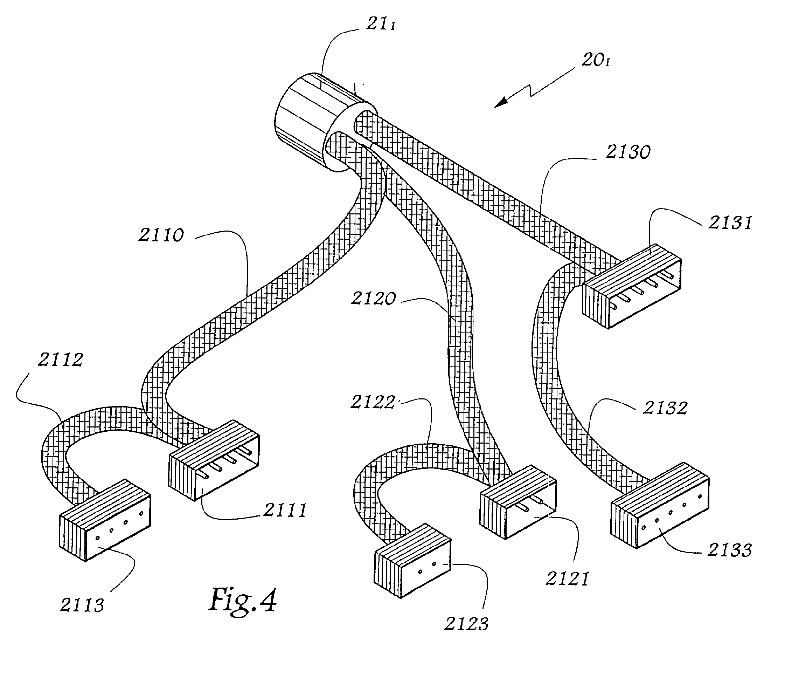

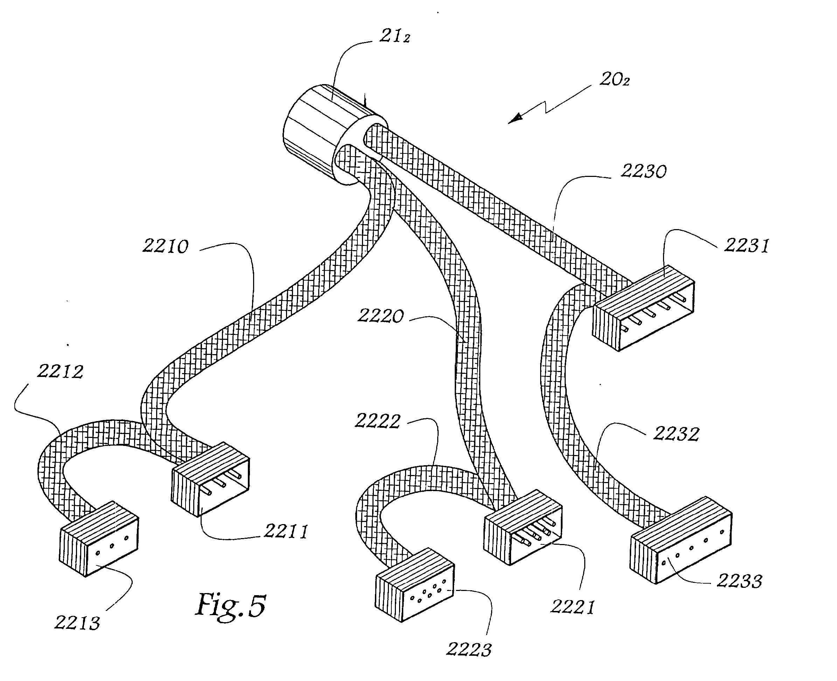

Chacun des cordons 20₁, 20₂ et 20₃ représentés aux figures 4, 5 et 6 comprend donc un connecteur primaire 21₁, 21₂ ou 21₃ mâle à seize voies, avec une voie libre.

Le cordon 20₁ représenté à la figure 4 comprend trois câbles conducteurs 2110, 2120 et 2130 reliés au connecteur 21₁. Le câble 2110 comporte quatre conducteurs et est relié à un connecteur mâle à quatre voies 2111, lui-même relié, en parallèle et par un second câble 2112 à quatre conducteurs, à un connecteur femelle à quatre voies 2113. Le câble 2120 comporte deux conducteurs et est relié à un connecteur mâle à deux voies 2121, lui-même relié par un câble à deux conducteurs 2122, à un connecteur femelle à deux voies 2123. De la même manière, le câble 2130 est à cinq conducteurs et relié à un connecteur mâle à cinq voies 2131, lui même relié par un câble à cinq conducteurs 2132, à un connecteur femelle à cinq voies 2133.

Ainsi, le cordon 201 permet de raccorder le boîtier 1 à des connecteurs mâle ou femelle à deux, quatre et cinq voies.

De la même manière, le cordon 20₂ comprend trois câbles 2210, 2220 et 2230 comportant respectivement trois, sept et cinq conducteurs. Le câble 2210 est relié à un connecteur mâle à trois voies 2211 lui-même relié, par un câble 2212 à trois conducteurs, à un connecteur femelle à trois voies 2213. Des connecteurs mâle et femelle à sept voies 2221 et 2223 sont reliés entre eux par un câble à sept conducteurs 2222 et disposés à l'extrémité du câble 2220, alors que des connecteurs mâle et femelle 2231 et 2233, reliés par un câble à cinq conducteurs 2232, sont disposés à l'extrémité du connecteur 2230.

Ainsi, le cordon 20₂ permet de raccorder le boîtier 1 à des appareillages électriques munis d'un raccord mâle ou femelle à trois, cinq ou sept voies.

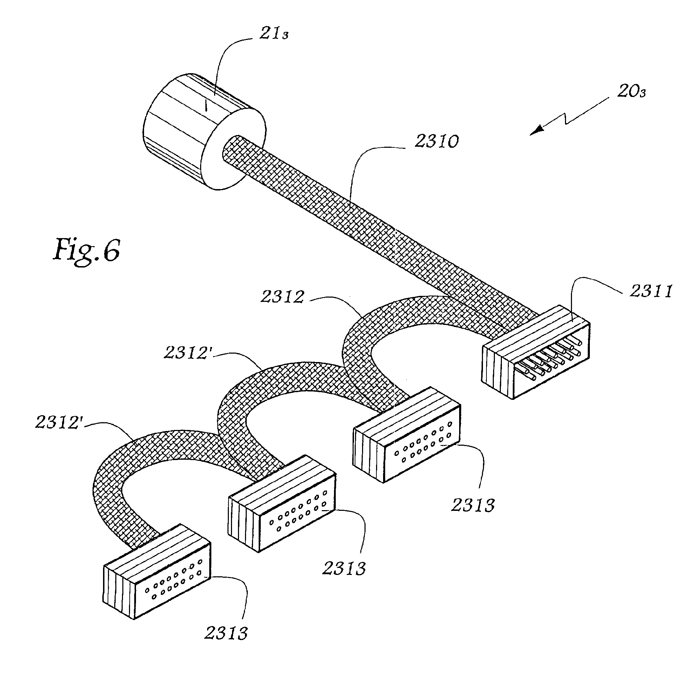

Le cordon 20₃ représenté à la figure 6 comprend un câble à quinze conducteurs 2310 relié au connecteur 21₃ et à un connecteur mâle à quinze voies 2311, sans verrou coulissant. Un second câble 2312 à quinze conducteurs est branché en parallèle sur le connecteur 2311 et permet d'alimenter trois connecteurs femelles 2313 à quinze voies sans verrou coulissant reliés entre eux par des câbles 2312' à quinze conducteurs.

Ainsi, le cordon 20₃ permet de raccorder le boîtier 1 à des appareils équipés de connecteurs à quinze voies sans verrou. Un cordon équivalent au cordon 20₃ peut également être prévu pour des connecteurs avec verrou coulissant monté à la place des connecteurs 2311 et 2313.

Bien entendu, le nombre et la structure des cordons 20₁, 20₂, 20₃ ou équivalent du système de l'invention peut être adapté en fonction des connecteurs utilisés dans les véhicules automobiles du marché. En particulier, si un nouveau connecteur est employé, il suffit de créer un nouveau cordon 20 adapté. Les connecteurs 2111, 2113, 2121, 2123, 2131, 2133, 2211, 2213, 2221, 2223, 2231, 2233, 2311 et 2313 constituent des exemples de connecteurs secondaires 22. Plusieurs connecteurs de même type peuvent, si besoin, être prévus sur un même cordon 20. La structure des connecteurs permet de connecter simultanément plusieurs appareils au boîtier 1 en utilisant plusieurs connecteurs d'un même cordon. Il est ainsi possible de vérifier le fonctionnement de différents composants d'un ensemble fonctionnel. Cette vérification peut concerner un appareil à la fois.

On comprend que les connecteurs primaire ou secondaires de chacun des cordons 20 peuvent être identifiés de façon univoque par une référence numérique ou un code de couleur, de façon à être aisément repérables par un technicien qui, en fonction des informations portées sur la fiche 41 et/ou la plaquette 51, sait immédiatement quel connecteur utiliser selon l'appareil 30 à vérifier.

Selon un aspect avantageux de l'invention, plus particulièrement visible à la figure 7, les connecteurs sont légèrement modifiés par rapport aux connecteurs du commerce en ce sens qu'ils ne comprennent pas de système de détrompage ou, plus précisément, que la partie correspondante de leur enveloppe externe a été supprimée, de telle sorte qu'ils sont compatibles avec les différents connecteurs utilisés sur les appareils 30, 301 ou équivalents dans un véhicule automobile. Il convient en effet de noter que plusieurs connecteurs du même type, par exemple mâle et à cinq voies, peuvent être utilisés dans un véhicule automobile, un tel connecteur étant représenté avec la référence 31' à la figure 7. Ces différents connecteurs mâles à cinq voies portent trois plots 32 prévus pour pénétrer dans des rainures 2134 d'une partie inférieure 2135 de l'enveloppe du connecteur 2133. Cette structure est commune à tous les connecteurs à cinq voies. Pour éviter des erreurs lors de l'assemblage du véhicule ou lors d'opérations de maintenance, il est connu d'équiper chaque connecteur 31' correspondant à une fonction d'un système de détrompage formé par des plots superficiels 33 prévus pour s'engager dans des nervures internes d'un connecteur femelle du véhicule. Comme le connecteur 2133 du système de l'invention doit pouvoir coopérer avec différents connecteurs 31' de différents appareils 30, la partie correspondante 2136 de son enveloppe, à savoir la partie supérieure sur la figure 7, est usinée pour retirer de la matière et créer ainsi une zone 2137 de réception des plots 33 du connecteur 32, quel que soit leur emplacement exact.

En d'autres termes, la création de la zone 2137 permet de rendre le connecteur 2133 compatible avec l'ensemble des connecteurs mâles à cinq voies 31' du véhicule.

L'invention a été représentée avec une documentation 40 sous forme de fiches 41. Il est bien entendu que cette documentation peut être constituée d'un fichier informatique, par exemple inscrit sur un support de type CD-room ou équivalent.

L'invention a été représentée avec un système incorporant une rallonge 3 et plusieurs cordons 20. La rallonge qui a une longueur de l'ordre du mètre, permet d'utiliser des cordons relativement courts, par exemple de longueur égale à environ 25 cm, sans imposer à l'utilisateur de disposer le boîtier 1 à proximité immédiate de l'appareil 30 à contrôler. Cependant, un système sans rallonge, dans lequel les cordons 20 ou équivalents seraient directement branchés sur le boîtier 1, est envisageable dans le cadre de la présente invention.

Par ailleurs, selon une variante non représentée de l'invention, il est possible d'utiliser plusieurs cordons 20 branchés en parallèle sur le boîtier 1, par exemple lorsque l'appareil 30 comporte plusieurs connecteurs d'interface 31.

Le système de l'invention peut fonctionner sans le jeu de plaquettes 50 dans la mesure où un technicien averti, qui connaît le boîtier 1, peut s'en servir directement à partir de la documentation 40.

Par ailleurs, une des plaquettes 51 peut être vierge alors que des marqueurs, effaçables ou non, sont prévus pour que l'utilisateur puisse, en cas de besoin, configurer cette plaquette en fonction d'un type d'appareil 30 non prévu dans la documentation 40. Ceci permet de prendre en compte les évolutions futures des véhicules du marché et/ou l'apparition de nouveaux types de connecteurs, auquel cas un cordon est prévu dans lequel un connecteur secondaire est remplacé par des fiches isolées, mâles et/ou femelles, pouvant être raccordées dans toutes les positions.

Dans la présente description, la notion d'appareil électrique ou électronique couvre tout type d'appareil alimenté ou contrôlé électriquement ou d'appareil fournissant un courant. Un appareil électrique ou électronique peut inclure des pièces en mouvement.

## Revendications

1. Système de diagnostic de panne affectant un appareil électrique ou électronique (30) d'un véhicule automobile, ledit système comprenant :
- un boîtier (1) comprenant plusieurs bornes de contrôle (104),
- un jeu de cordons (3, 20) permettant de relier lesdites bornes de contrôle à différents appareils électriques ou électroniques dudit véhicule, lesdits cordons étant aptes à être branchés sur au moins un connecteur (31) prévu sur ledit appareil et
- des outils (40, 50) de guidage d'un utilisateur pour le raccordement desdites bornes de contrôle, en fonction du ou des cordons utilisés et de l'appareil (30) sur un connecteur (31) duquel est raccordé ledit boîtier par ledit ou lesdits cordons
caractérisé en ce que ledit boîtier est équipé de bornes d'alimentation/simulation (111, 112, 121, 122, 131, 141, 142, 151, 152) aptes à être reliées électriquement auxdites bornes de contrôle (104).

2. Système selon la revendication 1, caractérisé en ce que ledit boîtier (1) est équipé d'un connecteur (2) dont le nombre de voies est au moins égal au nombre de bornes de contrôle.

3. Système selon l'une des revendications 1 ou 2, caractérisé en ce que ledit jeu de cordons inclut une rallonge (3) comprenant un cordon primaire (5) formé de conducteurs électriques en nombre au moins égal au nombre de bornes de contrôle (104) et un cordon (7) d'alimentation dudit boîtier (1) apte à être relié aux bornes d'une batterie d'accumulateurs (10) dudit véhicule.

4. Système selon l'une des revendications 1 à 3, caractérisé en ce que ledit jeu de cordons comprend plusieurs cordons (20) équipés d'un connecteur primaire (21) de nombre de voies supérieur ou égal au nombre de bornes de contrôle (14) et de plusieurs connecteurs secondaires (22) de nombre de voies et de géométrie variables.

5. Système selon la revendication 4, caractérisé en ce que lesdits connecteurs secondaires (22) comprennent plusieurs connecteurs mâles et/ou femelles (2111, 2113, 2121, 2123, 2131, 2133, 2211, 2213, 2221, 2223, 2231, 2233, 2311, 2313) reliés en parallèle audit connecteur primaire (21).

6. Système selon l'une des revendications 4 ou 5, caractérisé en ce que lesdits connecteurs secondaires (22) sont rendus compatibles avec des connecteurs (32) de même nombre de voies prévus sur lesdits appareils (30), indépendamment d'un éventuel système de détrompage par suppression d'une partie (2136) desdits connecteurs secondaires (2133) intégrant habituellement un système de détrompage (33), notamment par enlèvement de matière.

7. Système selon l'une des revendications précédentes, caractérisé en ce que lesdites bornes d'alimentation/simulation comprennent
- la ou les borne(s) de sortie (111, 112) d'une alimentation en tension continue variable (103₁) ;
- les bornes (121, 122) d'une résistance variable (103₂) ;
- une borne (131) d'un testeur de polarité (103₃) ;
- les bornes (141, 142) d'un générateur d'impulsions (103₄) et/ou
- des bornes (151, 152) reliées aux bornes de la batterie d'accumulateurs (10) du véhicule.

8. Système selon l'une des revendications précédentes, caractérisé en ce qu'il comprend un jeu (50) de plaquettes (51) aptes à être sélectivement disposées sur une façade (101) sur laquelle sont prévues lesdites bornes de contrôle (104), en fonction du ou des cordons utilisés (20) et de l'appareil à vérifier (30), chaque plaquette portant des moyens d'identification des bornes de contrôle permettant d'identifier l'affectation des voies dudit connecteur (31).

9. Système selon l'une des revendications précédentes, caractérisé en ce qu'il comprend une documentation (40) permettant de sélectionner, en fonction du véhicule et de l'appareil (30) à vérifier, un cordon (20) à utiliser et de connaître les branchements (107) à effectuer entre les bornes du boîtier et de spécifier les résultats à obtenir.

10. Procédé de diagnostic de panne affectant un appareil électrique ou électronique (30) d'un véhicule automobile, procédé dans lequel on branche un boîtier (1) comprenant plusieurs bornes de contrôle (104) sur au moins un connecteur (31) dudit appareil (30) et l'on vérifie le fonctionnement dudit appareil, caractérisé en ce qu'il comprend une étape consistant à :
- relier (107) lesdites bornes de contrôle (104) avec certaines bornes d'alimentation/simulation (111, 112, 121, 122, 131, 141, 142, 151, 152) prévues sur ledit boîtier (1), selon des indications fournies par des outils de guidage (40, 50) en fonction du type dudit appareil (30) et du ou des cordons (20) utilisés pour brancher ledit boîtier sur ledit connecteur (31).

11. Procédé selon la revendication 10, caractérisé en ce qu'il consiste à simuler, au niveau du connecteur (312) d'entrée d'un appareil (302), des conditions normales de fonctionnement de cet appareil, sans utilisation d'une unité de commande (400) dudit véhicule, et à vérifier le fonctionnement dudit appareil.
